# EUROPEAN PATENT APPLICATION

(11) **EP 4 810 564 A1**
(43) Date of publication of application: **23.09.2026**
(21) Application number: 24891351.9
(22) Date of filing: 08.11.2024
(51) Int. Cl.: C08L 27/06, C08J 3/18, C08K 5/10

(54) **GEL COMPOSITION, MEMBER, ELECTRONIC ELEMENT, ELECTRONIC DEVICE, AND METHOD FOR PRODUCING GEL COMPOSITION**

(30) Priority: 13.11.2023 JP 2023193219
(71) Applicant: SHIN-ETSU CHEMICAL CO., LTD., Tokyo 100-0005 (JP); Shinshu University, Matsumoto-shi, Nagano 390-8621 (JP)
(72) Inventor: SASADA Yoshihito, Kamisu-shi, Ibaraki 314-0102 (JP); SAITO Hiroaki, Kamisu-shi, Ibaraki 314-0102 (JP); KAWAKUBO Toshihiko, Kamisu-shi, Ibaraki 314-0102 (JP); HIRAI Toshihiro, Ueda City, Nagano 386-8567 (JP)
(74) Representative: Pfenning, Meinig & Partner mbB
(86) International application number: PCT/JP2024/039890
(87) International publication number: WO 2025/105315

(57) **Abstract**

Provided is a gel composition including a polyvinyl chloride-based resin and a plasticizer and exhibiting a gel state at 20°C. The plasticizer is at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof. Provided is an electronic element including a first electrode and a second electrode, and a polymer layer which is arranged between the first electrode and the second electrode and includes the gel composition.

## Description

### TECHNICAL FIELD

The present invention relates to a gel composition, a member, an electronic element, an electronic device, and a method for producing the gel composition.

### BACKGROUND ART

Patent Documents 1 to 5 disclose that a gel-like substance containing polyvinyl chloride and dibutyl adipate can be used as a derivative of an actuator or a sensor. Patent Document 6 discloses an actuator including a PVC gel sheet containing polyvinyl chloride and diethyl adipate, dioctyl adipate, diethyl sebacate, dioctyl sebacate, or diethyl succinate.

### RELATED ART DOCUMENTS

### PATENT DOCUMENTS

Patent Document 1: Japanese Patent No. 5392669
Patent Document 2: Japanese Patent No. 5914003
Patent Document 3: Japanese Patent Application Publication No. 2021-112018
Patent Document 4: Japanese Patent Application Publication No. 2021-164395
Patent Document 5: Japanese Patent Application Publication No. 2021-161365
Patent Document 6: Japanese Patent Application Publication No. 2021-161364

### GENERAL DISCLOSURE

In a first aspect of the present invention, a gel composition including a polyvinyl chloride-based resin and a plasticizer is provided. The gel composition exhibits a gel state at 20°C. The plasticizer may be at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof.

In the above, the plasticizer may be at least one selected from a group consisting of di-2-ethylhexyl isophthalate (DOIP), di-2-ethylhexyl terephthalate (DOTP), dibutyl fumarate (DBF), di-2-ethylhexyl fumarate (DOF), methyl acetyl ricinoleate (MAR), acetyl tributyl citrate (ATBC), diethyl fumarate (DEF), diethyl maleate (DEM), dibutyl maleate (DBM), triethyl citrate (TEC), tributyl citrate (TBC) and derivatives thereof, and salts thereof.

In the above, in the gel composition, in a state in which a voltage of 300 V is applied to a sample having a height of 1.5 cm, a width of 1.5 cm, and a thickness of 0.03 cm, using an aluminum electrode as an anode, a tack force measured as a force required to peel the sample in contact from the anode may be 0.5 N/cm² or more.

In the above, in the gel composition, when a voltage of 300 V is applied to a sample having a height of 1.5 cm, a width of 1.5 cm, and a thickness of 0.03 cm, using a stainless-steel mesh electrode having a wire diameter of 0.18 mm, an opening size of 0.67 mm, and an aperture ratio of 62% as an anode, a displacement of the sample may be 0.5 µm or more.

In the above, the plasticizer may be at least one selected from a group consisting of di-2-ethylhexyl isophthalate (DOIP) and derivatives thereof, and salts thereof. The gel composition may include (i) 1000 parts by mass or less of the plasticizer with respect to 100 parts by mass of the polyvinyl chloride-based resin. In addition to and/or instead of this, the gel composition may include (ii) 200 parts by mass or more of the plasticizer with respect to 100 parts by mass of the polyvinyl chloride-based resin.

In the above, the plasticizer may be at least one selected from a group consisting of di-2-ethylhexyl terephthalate (DOTP) and derivatives thereof, and salts thereof. The gel composition may include 200 parts by mass or more of the plasticizer with respect to 100 parts by mass of the polyvinyl chloride-based resin.

In a second aspect of the present invention, a member formed from any of the above compositions is provided.

In a third aspect of the present invention, an electronic element including a first electrode, a second electrode, and a polymer layer is provided. The polymer layer is arranged between the first electrode and the second electrode, and includes the gel composition according to any one of claims 1 to 6.

In a fourth aspect of the present invention, a method for producing the gel composition is provided, which includes mixing and removing. In the mixing, a polyvinyl chloride-based resin, a plasticizer, and a solvent may be mixed. In the removing, a mixture of the polyvinyl chloride-based resin, the plasticizer, and the solvent obtained in the mixing may be dried to remove a part of the solvent from the mixture. The mixture may include 100 parts by mass or more and 1000 parts by mass or less of the plasticizer with respect to 100 parts by mass of the polyvinyl chloride-based resin. The plasticizer may be at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof.

In a fifth aspect of the present invention, a ratio of a total mass of the polyvinyl chloride-based resin and the plasticizer to a mass of the mixture may be 80 mass% or more. The plasticizer may be at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof.

In a sixth aspect of the present invention, a gel composition including a polyvinyl chloride-based resin and a plasticizer and exhibiting a gel state at 20°C is provided. A product of a tack force (N/cm²) of the gel composition and a displacement (µm) of a sample is 20 µm·N/cm² or more. The tack force is measured as a force required to peel a sample in contact from an anode, in a state in which a voltage of 300 V is applied to the sample having a height of 1.5 cm, a width of 1.5 cm, and a thickness of 0.03 cm, using an aluminum electrode as the anode. The displacement of the sample is a displacement when a voltage of 300 V is applied to the sample having a height of 1.5 cm, a width of 1.5 cm, and a thickness of 0.03 cm, using a stainless-steel mesh electrode having a wire diameter of 0.18 mm, an opening size of 0.67 mm, and an aperture ratio of 62% as an anode.

In a seventh aspect of the present invention, a gel composition including a polyvinyl chloride-based resin and a plasticizer and exhibiting a gel state at 20°C is provided. A displacement/tack force obtained by dividing a displacement (µm) of a sample by a tack force (N/cm²) of the gel composition is 1.5 µm·cm²/N or more. The tack force is measured as a force required to peel the sample in contact from an anode, in a state in which a voltage of 300 V is applied to the sample having a height of 1.5 cm, a width of 1.5 cm, and a thickness of 0.03 cm, using the aluminum electrode as the anode. The displacement of the sample is a displacement when a voltage of 300 V is applied to the sample having a height of 1.5 cm, a width of 1.5 cm, and a thickness of 0.03 cm, using a stainless-steel mesh electrode having a wire diameter of 0.18 mm, an opening size of 0.67 mm, and an aperture ratio of 62% as an anode.

The summary clause does not necessarily describe all necessary features of the embodiments of the present invention. The present invention may also be a sub-combination of the features described above.

### BRIEF DESCRIPTION OF THE DRAWINGS

FIG. 1 is a diagram schematically illustrating an example of a system configuration of an actuator 100.
FIG. 2 is a diagram schematically illustrating an example of a system configuration of a sensor 200.
FIG. 3 is a diagram schematically illustrating an example of a method for preparing a polymer layer 116.

### DESCRIPTION OF EXEMPLARY EMBODIMENTS

Hereinafter, (some) embodiment(s) of the present invention will be described, but the embodiment(s) do(es) not limit the invention according to the claims. Not all combinations of features described in the embodiments are necessarily essential for a solution of the invention. Also, the embodiment(s) will be described with reference to the drawings. The identical or similar parts in the drawings may be given the same reference numerals to omit the description that could otherwise overlap.

### (Overview of actuator 100)

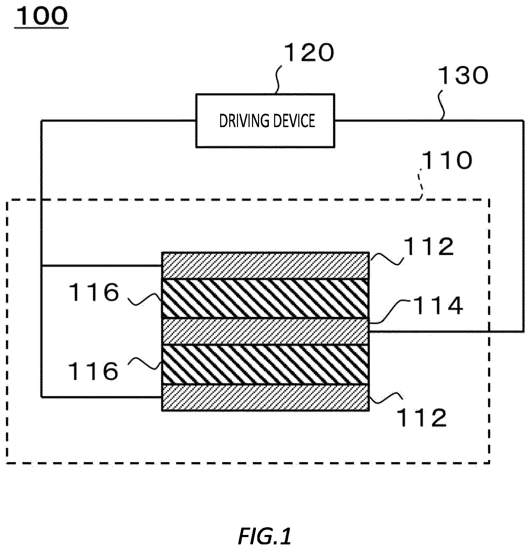

FIG. 1 schematically illustrates an example of a system configuration of an actuator 100. The actuator 100 converts electrical energy into mechanical energy.

In the present embodiment, the actuator 100 includes, for example, a piezoelectric element 110, a driving device 120, and a wiring 130. In the present embodiment, the piezoelectric element 110 includes, for example, a cathode 112, an anode 114, and a polymer layer 116. The polymer layer in the present embodiment is a member formed from a gel composition. More specifically, the piezoelectric element 110 includes two cathodes 112, one anode 114, and two polymer layers 116. In the present embodiment, the cathode 112, the polymer layer 116, the anode 114, the polymer layer 116, and the cathode 112 are arranged in this order.

In the present embodiment, the piezoelectric element 110 converts the electrical energy into the mechanical energy by utilizing an inverse piezoelectric effect of the polymer layer 116. As described above, in the present embodiment, the piezoelectric element 110 includes a pair of the cathode 112 and the anode 114, and the polymer layer 116 arranged between the pair of the cathode 112 and the anode 114. In one embodiment, a part of the polymer layer 116 is arranged between the pair of the cathode 112 and the anode 114. For example, one end of the polymer layer 116 and a vicinity thereof are arranged between the pair of the cathode 112 and the anode 114. In another embodiment, an entirety of the polymer layer 116 is arranged between the pair of the cathode 112 and the anode 114.

The pair of the cathode 112 and the anode 114 applies a voltage to the polymer layer 116 arranged between the paired cathode 112 and anode 114. The polymer layer 116 deforms in accordance with a magnitude of the applied voltage. The voltage applied at this time may be adjusted as appropriate, but is preferably 10 to 500 V, more preferably 20 to 400 V.

The cathode 112 and the anode 114 may be any members capable of applying a voltage to the polymer layer 116, and materials and structures of the cathode 112 and the anode 114 are not particularly limited. Examples of the structures of the cathode 112 and the anode 114 include shape, planar dimensions, thickness, and the like. Examples of the shapes of the cathode 112 and the anode 114 include a plate shape, a foil shape, a comb shape, a mesh shape, and the like.

At least one of the cathode 112 or the anode 114 may have the comb shape or the mesh shape. In particular, when the anode 114 has the mesh shape, the polymer layer 116 can enter void portions of a mesh to cause shrinkage. The cathode 112 and/or the anode 114 having the comb shape or the mesh shape can be easily deformed. This reduces power consumption of the actuator 100.

In the present embodiment, the polymer layer 116 is a polymer layer including the polyvinyl chloride-based resin and a plasticizer. The polymer layer 116 exhibits a gel state at 20°C. The term "gel state" refers to a state generally called "gel", which is a mixed system of two or more components. For example, the "gel" has intermediate properties between a solid and a liquid and may be a swollen body of the polymer that has absorbed a polymer or a solvent, or the like. Also, for example, the "gel" is considered to be a state in which polymer chains are connected to be very long in a network form.

In one embodiment, the polymer layer 116 includes a piezoelectric material. The polymer layer 116 may be the piezoelectric material. Thus, when pressure is applied to the polymer layer 116, voltage proportional to a magnitude of the pressure is generated. Also, when voltage is applied to the polymer layer 116, the polymer layer 116 is deformed. The piezoelectric material may be a type of dielectric.

In another embodiment, the polymer layer 116 has tackiness. The tackiness is an index indicating a degree of stickiness of a surface of a material. The polymer layer 116 may include a piezoelectric material having the tackiness, and the polymer layer 116 may be the piezoelectric material having the tackiness. In still another embodiment, the polymer layer 116 may have an optical path bending characteristic. Details of the polymer layer 116 will be described later.

In the present embodiment, the driving device 120 controls an operation of the actuator 100. In one embodiment, the driving device 120 controls a timing at which voltage is applied to the piezoelectric element 110. In another embodiment, the driving device 120 controls a magnitude of the voltage applied to the piezoelectric element 110. In the present embodiment, the wiring 130 electrically connects the piezoelectric element 110 and the driving device 120.

The actuator 100 may be an example of the electronic device. The piezoelectric element 110 may be an example of the electronic element. The polymer layer 160 may be an example of the gel composition. The cathode 112 may be an example of one of the first electrode or the second electrode. The anode 114 may be an example of another of the first electrode or the second electrode.

### (One example of another embodiment)

In the present embodiment, details of the piezoelectric element 110 have been described by taking as an example a case where the piezoelectric element 110 includes two cathodes 112, one anode 114, and two polymer layers 116, and the cathode 112, the polymer layer 116, the anode 114, the polymer layer 116, and the cathode 112 are arranged in this order. However, the piezoelectric element 110 is not limited to the present embodiment. For example, a structure of the piezoelectric element 110, a number of at least one part constituting the piezoelectric element 110, and/or a shape of each part constituting the piezoelectric element 110 are not limited to the present embodiment.

In another embodiment, the piezoelectric element 110 includes one or a plurality of (which may be referred to as one or more) unit cells including the cathode 112, the polymer layer 116, and the anode 114. In the unit cell, the cathode 112, the polymer layer 116, and the anode 114 are arranged, for example, in this order. In the unit cell, the polymer layer 116 may be in contact with the cathode 112 and the anode 114. The unit cell may have, between the cathode 112 and the anode 114, a sheet-like, film-like, or layer-like member different from the polymer layer 116. When the piezoelectric element 110 includes a plurality of single unit cells, adjacent unit cells may share a single cathode 112, and adjacent unit cells may share a single anode 114. When the piezoelectric element 110 includes a plurality of single unit cells, the plurality of unit cells may be combined such that an outermost layer of the piezoelectric element 110 is the cathode 112, and the plurality of unit cells may be combined such that the outermost layer of the piezoelectric element 110 is the anode 114.

In still another embodiment, a plurality of polymer layers 116 may be arranged between the cathode 112 and the anode 114. The piezoelectric element 110 includes, for example, the plurality of mutually independent polymer layers 116 between the cathode 112 and the anode 114. Each of the plurality of polymer layers 116 may have a substantially polygonal prismatic shape, a substantially polygonal pyramidal shape, a substantially cylindrical shape, a substantially conical shape, a substantially elliptic cylindrical shape, or a substantially elliptic conical shape, and may have a shape similar thereto.

In the present embodiment, details of the actuator 100, which is an example of the electronic device, have been described. However, the electronic device is not limited to the actuator 100 according to the present embodiment. In another embodiment, the electronic device may be any device that uses the inverse piezoelectric effect or a piezoelectric effect of the polymer layer 116.

The electronic device may be any type of actuator that uses an inverse piezoelectric effect of the polymer layer 116, or may be a device including the actuator. The device including the actuator may be a device that uses the actuator as a power source. Examples of the device that uses the actuator as a power source include an artificial muscle, a robot suit, a robot hand, a variable-focus lens, a vibration generator, a tactile display, and the like. Examples of the vibration generator include a speaker, a vibration speaker, a bone-conduction speaker, and the like.

The electronic device may be any type of sensor that uses the piezoelectric effect of the polymer layer 116, or may be a device including the sensor. Details of the sensor will be described later.

In the present embodiment, an example of an application of the polymer layer 116 has been described by taking as an example a case where the piezoelectric effect or the inverse piezoelectric effect of the polymer layer 116 is used. However, the application of the polymer layer 116 is not limited to the present embodiment. In another embodiment, the tackiness of the polymer layer 116 is used. The polymer layer 116 is used, for example, as an adsorption material, an adhesive material, or the like. The polymer layer 116 may constitute a part of an air purifier or an electrostatic flocking device. In still another embodiment, the optical path bending characteristic of the polymer layer 116 is utilized. The polymer layer 116 constitutes, for example, a part of an optical scanning device or the display.

### (Overview of sensor 200)

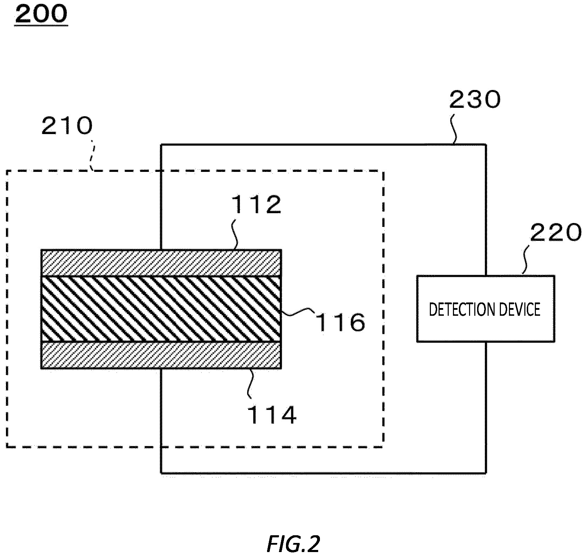

FIG. 2 schematically illustrates an example of a system configuration of a sensor 200. The sensor 200 converts mechanical energy into electrical energy.

In the present embodiment, the sensor 200 includes, for example, a piezoelectric element 210, a detection device 220, and a wiring 230. In the present embodiment, the piezoelectric element 210 includes, for example, the cathode 112, the anode 114, and the polymer layer 116. More specifically, the piezoelectric element 110 includes one cathode 112, one anode 114, and one polymer layer 116. In the present embodiment, the cathode 112, the polymer layer 116, and the anode 114 are arranged in this order.

In the present embodiment, the piezoelectric element 210 converts mechanical energy into electrical energy by utilizing the piezoelectric effect of the polymer layer 116. As described above, in the present embodiment, the piezoelectric element 210 includes a pair of the cathode 112 and the anode 114, and the polymer layer 116 arranged between the pair of the cathode 112 and the anode 114. In one embodiment, a part of the polymer layer 116 is arranged between the pair of the cathode 112 and the anode 114. For example, one end of the polymer layer 116 and a vicinity thereof are arranged between the pair of the cathode 112 and the anode 114. In another embodiment, an entirety of the polymer layer 116 is arranged between the pair of the cathode 112 and the anode 114.

In the present embodiment, when pressure is applied to the polymer layer 116 arranged between the pair of the cathode 112 and the anode 114, a potential difference (which may be referred to as voltage) is generated between the pair of the cathode 112 and the anode 114. The pair of the cathode 112 and the anode 114 is connected to the detection device 220 via the wiring 230. For example, the cathode 112 is electrically connected to one input terminal of the detection device 220, and the anode 114 is electrically connected to another input terminal of the detection device 220.

The cathode 112 and the anode 114 may be any members having conductivity, and materials and structures of the cathode 112 and the anode 114 are not particularly limited. Examples of the structures of the cathode 112 and the anode 114 include shape, planar dimensions, thickness, and the like. Examples of shapes of the cathode 112 and the anode 114 include a plate shape, a foil shape, a comb shape, a mesh shape, and the like.

At least one of the cathode 112 or the anode 114 may have the comb shape or the mesh shape. In particular, the anode 114 may have the mesh shape. The cathode 112 and/or the anode 114 having the comb shape or the mesh shape can be easily deformed. This facilitates the polymer layer 116 entering gaps of the mesh, thereby improving sensitivity of the sensor 200.

In the present embodiment, the detection device 220 detects the voltage generated between the pair of the cathode 112 and the anode 114. The detection device 220 may measure a magnitude of the voltage described above by any known method. In the present embodiment, the wiring 230 electrically connects the piezoelectric element 210 and the detection device 220.

The sensor 200 may be an example of the electronic device. The piezoelectric element 210 may be an example of the electronic element.

### (One example of another embodiment)

In the present embodiment, details of the piezoelectric element 210 have been described by taking as an example a case where the piezoelectric element 210 includes one cathode 112, one anode 114, and one polymer layer 116, and the cathode 112, the polymer layer 116, and the anode 114 are arranged in this order. However, the piezoelectric element 210 is not limited to the present embodiment. For example, a structure of the piezoelectric element 210, a number of at least one part constituting the piezoelectric element 210, and/or a shape of each part constituting the piezoelectric element 210 are not limited to the present embodiment. The piezoelectric element 210 may have a configuration similar to that of the other embodiments described in relation to the piezoelectric element 110.

### (Details of the polymer layer 116)

In the present embodiment, the polymer layer 116 includes a gel-like composition (which may be referred to as a gel composition). The polymer layer 116 may be the gel composition. The gel composition described above includes, for example, a polyvinyl chloride-based resin and a plasticizer. The gel composition described above exhibits, for example, a gel state at 20°C. The gel composition described above preferably exhibits the gel state at a temperature of -10°C or higher and 50°C or lower, and more preferably exhibits the gel state at a temperature of 5°C or higher and 35°C or lower.

### (A. Composition of gel composition)

### (Polyvinyl chloride-based resin)

In the present embodiment, the polyvinyl chloride-based resin may be (i) a homopolymer of a vinyl chloride monomer, (ii) a copolymer of a vinyl chloride monomer and one or more other polymerizable monomers, or (iii) a chlorinated product of the polymer of (i) or the copolymer of (ii). The other polymerizable monomer may be any compound copolymerizable with the vinyl chloride monomer, and details thereof are not particularly limited. When the polyvinyl chloride-based resin is a copolymer, a type of the other polymerizable monomer described above may be selected so that it becomes easy to form the polyvinyl chloride-based resin into a sheet shape, a film shape, or a layer shape in a state where a plasticizer is added.

The other polymerizable monomer may be a compound including an ethylenically unsaturated group. The compound including an ethylenically unsaturated group may be a compound having one ethylenically unsaturated group in one molecule, or may be a compound having a plurality of ethylenically unsaturated groups in one molecule.

Examples of the compound including an ethylenically unsaturated group include ethylene, propylene, vinylidene chloride, vinyl acetate, vinyl carboxylic acid monomers, aromatic vinyl monomers, conjugated diene monomers, ethylenically unsaturated monocarboxylic acid esters, ethylenically unsaturated polycarboxylic acid esters, ethylenically unsaturated monocarboxylic acids, ethylenically unsaturated dicarboxylic acids, ethylenically unsaturated ethers, epoxy group-containing monomers, alcoholic hydroxyl group-containing monomers, alkoxyl group-containing monomers, nitrile group-containing monomers, amide group-containing monomers, amino group-containing monomers, and the like.

The polyvinyl chloride-based resin may not substantially contain impurities mixed in raw materials of the polyvinyl chloride-based resin and/or in a manufacturing process of the polyvinyl chloride-based resin (which may be referred to as unavoidable impurities).

A K value of the polyvinyl chloride-based resin is not particularly limited, but may be, for example, in a range of 40 to 110, and is preferably 45 to 105. The K value is measured in accordance with JIS K 7367-2. Examples of commercially available polyvinyl chloride-based resins having such a K value include TK-2500HS, TK-2000E (manufactured by Shin-Etsu Chemical Co., Ltd.), VICIR S2000 (manufactured by Cires), VICIR S5000 (manufactured by Cires), and the like.

### (Plasticizer)

### (Type of plasticizer)

In the present embodiment, the plasticizer may be at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof. Thus, the gel composition containing the above plasticizer and the above-described polyvinyl chloride-based resin can serve as a piezoelectric material.

As described above, Patent Documents 1 to 5 disclose that a PVC gel containing polyvinyl chloride and dibutyl adipate (which may be referred to as dibutyl adipate) was prepared. Patent Documents 1 to 5 describe that various compounds can be used as the plasticizer, but, as examples, merely disclose the PVC gel containing dibutyl adipate as the plasticizer. In addition, Patent Documents 1 to 5 neither describe nor suggest a relationship between an amount of plasticizer added and a degree of inverse piezoelectric effect of the PVC gel. Further, Patent Documents 1 to 5 neither describe nor suggest a relationship between a type and/or amount of plasticizer added and tackiness of the PVC gel.

Patent Document 6 discloses that a PVC gel sheet containing polyvinyl chloride and diethyl adipate, dioctyl adipate, diethyl sebacate, dioctyl sebacate, or diethyl succinate was prepared. Patent Document 6 also describes that the PVC gel sheet was prepared while changing a concentration of the plasticizer, but does not describe specific experimental results. In addition, Patent Document 6 neither describes nor suggests a relationship between the amount of plasticizer added and the degree of inverse piezoelectric effect of the PVC gel. Further, Patent Document 6 neither describes nor suggests a relationship between the type and/or amount of plasticizer added and the tackiness of the PVC gel.

The present inventors have found that, when the plasticizer is at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof, a gel composition containing the plasticizer and the above-described polyvinyl chloride-based resin can serve as a piezoelectric material. The present inventors have also found that the above gel composition has excellent tackiness.

Furthermore, the present inventors changed the amount of plasticizer added for each of the above gel compositions, and observed changes in the degree of inverse piezoelectric effect and changes in the degree of tackiness of each gel composition. As a result, the present inventors have found that, depending on a type of plasticizer, there may be differences in (i) a variation pattern of the degree of inverse piezoelectric effect of the gel composition when the amount of plasticizer added is changed, (i) a variation pattern of the degree of tackiness of the gel composition when the amount of plasticizer added is changed, (iii) a variation pattern of (degree of inverse piezoelectric effect)×(tackiness) of the gel composition when the amount of plasticizer added is changed, and/or (iv) a variation pattern of (degree of inverse piezoelectric effect/tackiness) of the gel composition when the amount of plasticizer added is changed. Note that the degree of inverse piezoelectric effect can also indicate a degree of piezoelectric effect.

Specifically, the present inventors have found that there are plasticizers of a type in which the degree of inverse piezoelectric effect of the gel composition increases as the amount added increases, and plasticizers of a type in which the degree of inverse piezoelectric effect of the gel composition decreases as the amount added increases. The present inventors have also found that, depending on the type of plasticizer, the degree of inverse piezoelectric effect of the gel composition may have a local maximum value or a local minimum value.

The present inventors have found that there are plasticizers of a type in which the degree of tackiness of the gel composition increases as the amount added increases, and plasticizers of a type in which the degree of tackiness of the gel composition decreases as the amount added increases. The present inventors have also found that, depending on the type of plasticizer, the degree of tackiness of the gel composition may have a local maximum value or a local minimum value.

The present inventors have found that there are plasticizers of types such as a type in which (degree of inverse piezoelectric effect)×(tackiness) of the gel composition generally increases as the amount added increases, a type in which it increases once as the amount added increases but thereafter becomes constant, and a type in which it increases once as the amount added increases and then turns to decrease. The present inventors have also found that, depending on the type of plasticizer, (degree of inverse piezoelectric effect)×(degree of tackiness) of the gel composition may have a local maximum value or a local minimum value.

The present inventors have found that there are plasticizers of types such as a type in which, as the added amount increases, the degree of inverse piezoelectric effect/degree of tackiness of a gel composition generally increases, a type in which, as the added amount increases, the degree of inverse piezoelectric effect/degree of tackiness of a gel composition increases once but thereafter becomes constant, and a type in which, as the added amount increases, the degree of inverse piezoelectric effect/degree of tackiness of a gel composition increases once and then turns to a decrease. The present inventors have also found that, depending on the type of plasticizer, the degree of inverse piezoelectric effect/degree of tackiness of the gel composition may have a local maximum value or a local minimum value.

The plasticizer may include an ester of (i) isophthalic acid, terephthalic acid, fumaric acid, acetylricinoleic acid, acetylcitric acid, citric acid, adipic acid, or maleic acid and (ii) an alcohol having 1 to 20 carbon atoms (which may be linear, branched, or cyclic, may include an aromatic group, and may have a substituent), and may include a salt of the ester. Examples of the salt of the ester described above include carbonates, phosphates, sulfates, and the like.

The plasticizer is preferably at least one selected from a group consisting of di-2-ethylhexyl isophthalate (DOIP), di-2-ethylhexyl terephthalate (DOTP), dibutyl fumarate (DBF), di-2-ethylhexyl fumarate (DOF), methyl acetyl ricinoleate (MAR), acetyl tributyl citrate (ATBC), diethyl fumarate (DEF), diethyl maleate (DEM), dibutyl maleate (DBM), triethyl citrate (TEC), tributyl citrate (TBC) and derivatives thereof, and salts thereof.

When the plasticizer is di-2-ethylhexyl isophthalate (DOIP), di-2-ethylhexyl terephthalate (DOTP), diethyl fumarate (DEF), diethyl maleate (DEM), dibutyl maleate (DBM), triethyl citrate (TEC), or tributyl citrate (TBC), a gel composition having a higher degree of tackiness can be obtained as compared with the gel composition containing, as the plasticizer, di-2-ethylhexyl phthalate (DOP), which is a structural isomer of these compounds. In addition, as compared with a case where DOP is used as the plasticizer, a balance between the degree of inverse piezoelectric effect and the degree of tackiness can be easily adjusted.

Specifically, in a gel composition containing DOP as the plasticizer, as the added amount of the plasticizer increases, the degree of inverse piezoelectric effect of the gel composition increases, and the degree of tackiness of the gel composition sharply decreases. Therefore, it is relatively difficult to adjust the balance between the degree of inverse piezoelectric effect and the degree of tackiness by using DOP as the plasticizer. In contrast, in a gel composition containing DOIP as the plasticizer, as the added amount of the plasticizer increases, the degree of inverse piezoelectric effect of the gel composition increases, and the degree of tackiness of the gel composition decreases relatively gradually. In addition, in the gel composition containing DOTP as the plasticizer, as the added amount of the plasticizer increases, the degree of inverse piezoelectric effect of the gel composition increases, and the degree of tackiness of the gel composition also increases. In addition, the degree of tackiness has a local maximum value.

A gel composition containing DEF, DEM, DBM, TEC, or TBC as the plasticizer also shows a tendency that, as the added amount of the plasticizer increases, the degree of inverse piezoelectric effect of the gel composition generally increases. In addition, the gel composition shows a tendency that the degree of tackiness of the gel composition is substantially constant or decreases relatively gradually.

Thus, when DOTP and DOIP are used as the plasticizer, a gel composition having a high degree of tackiness can be prepared relatively easily. In particular, when DOTP is used as the plasticizer, a gel composition having a relatively high degree of inverse piezoelectric effect and a relatively high degree of tackiness can be prepared.

When the plasticizer is dibutyl fumarate (DBF), di-2-ethylhexyl fumarate (DOF), methyl acetyl ricinoleate (MAR), acetyl tributyl citrate (ATBC), diethyl fumarate (DEF), diethyl maleate (DEM), dibutyl maleate (DBM), triethyl citrate (TEC), and/or tributyl citrate (TBC), a gel composition having a high degree of tackiness can be obtained. When the plasticizer is dibutyl fumarate (DBF), di-2-ethylhexyl fumarate (DOF), methyl acetyl ricinoleate (MAR), and/or acetyl tributyl citrate (ATBC), for example, a gel composition having a higher degree of tackiness can be obtained as compared with a case where the plasticizer is dibutyl adipate (DBA) used in Patent Documents 1 to 6 described above. As a result, the balance between the degree of inverse piezoelectric effect and the degree of tackiness can be easily adjusted.

### (Content of plasticizer)

The gel composition may contain 100 parts by mass or more and 1000 parts by mass or less, preferably 200 parts by mass or more and 800 parts by mass or less, more preferably 250 parts by mass or more and 700 parts by mass or less, of the plasticizer with respect to 100 parts by mass of the polyvinyl chloride-based resin. Thus, a composition exhibiting a gel state at 20°C can be obtained. When content of the plasticizer is equal to or more than a lower limit value of the numerical range described above, a piezoelectric material exhibiting a gel state at 20°C can be obtained. When the content of the plasticizer is equal to or less than an upper limit value of the numerical range described above, the composition has appropriate viscosity and/or elasticity, and a sheet-shaped, film-shaped, or layered gel composition can be obtained.

When the plasticizer is DOIP, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. This provides the gel composition having a relatively high degree of inverse piezoelectric effect and a high degree of tackiness.

When the plasticizer is DOTP, the gel composition may contain 200 parts by mass or more of the plasticizer with respect to 100 parts by mass of the polyvinyl chloride-based resin. The gel composition may contain 250 parts by mass or more of the plasticizer with respect to 100 parts by mass of the polyvinyl chloride-based resin, and may contain 300 parts by mass or more of the plasticizer with respect to 100 parts by mass of the polyvinyl chloride-based resin. This provides the gel composition having a relatively high degree of inverse piezoelectric effect and a high degree of tackiness.

When the plasticizer is DOTP, the gel composition may contain 800 parts by mass or less, preferably 700 parts by mass or less, of the plasticizer with respect to 100 parts by mass of the polyvinyl chloride-based resin. The gel composition may contain 650 parts by mass or less of the plasticizer with respect to 100 parts by mass of the polyvinyl chloride-based resin, may contain 600 parts by mass or less of the plasticizer with respect to 100 parts by mass of the polyvinyl chloride-based resin, and may contain less than 600 parts by mass of the plasticizer with respect to 100 parts by mass of the polyvinyl chloride-based resin. The gel composition may contain 500 parts by mass or less of the plasticizer with respect to 100 parts by mass of the polyvinyl chloride-based resin. This provides the gel composition having a relatively high degree of inverse piezoelectric effect and a high degree of tackiness.

When the plasticizer is DBF, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 400 parts by mass or more of the plasticizer with respect to the polyvinyl chloride-based resin. This provides the gel composition having a relatively high degree of inverse piezoelectric effect and a high degree of tackiness.

When the plasticizer is DOF, the gel composition may contain 200 parts by mass or more and 800 parts by mass or less, preferably 250 parts by mass or more and 600 parts by mass or less, of the plasticizer with respect to 100 parts by mass of the polyvinyl chloride-based resin. The gel composition may contain 300 parts by mass or more of the plasticizer with respect to the polyvinyl chloride-based resin. This provides the gel composition having a relatively high degree of inverse piezoelectric effect and a high degree of tackiness.

When the plasticizer is MAR, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more of the plasticizer with respect to the polyvinyl chloride-based resin. This provides the gel composition having a relatively high degree of inverse piezoelectric effect and a high degree of tackiness.

When the plasticizer is ATBC, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more and 400 parts by mass or less of the plasticizer with respect to the polyvinyl chloride-based resin. This provides the gel composition having a relatively high degree of inverse piezoelectric effect and a high degree of tackiness.

When the plasticizer is DEF, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more of the plasticizer with respect to the polyvinyl chloride-based resin. This provides the gel composition having a relatively high degree of inverse piezoelectric effect and a high degree of tackiness.

When the plasticizer is DEM, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more of the plasticizer with respect to the polyvinyl chloride-based resin. This makes it possible to obtain the gel composition having a relatively large degree of inverse piezoelectric effect and a large degree of tackiness.

When the plasticizer is DBM, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more of the plasticizer with respect to the polyvinyl chloride-based resin. This makes it possible to obtain the gel composition having a relatively large degree of inverse piezoelectric effect and a large degree of tackiness.

When the plasticizer is TEC, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more of the plasticizer with respect to the polyvinyl chloride-based resin. This makes it possible to obtain the gel composition having a relatively large degree of inverse piezoelectric effect and a large degree of tackiness.

When the plasticizer is TBC, the gel composition may contain 200 parts by mass or more and 800 parts by mass or less, preferably 250 parts by mass or more and 500 parts by mass or less, of the plasticizer with respect to 100 parts by mass of the polyvinyl chloride-based resin. The gel composition may contain 300 parts by mass or more of the plasticizer with respect to the polyvinyl chloride-based resin. This makes it possible to obtain the gel composition having a relatively large degree of inverse piezoelectric effect and a large degree of tackiness.

When the plasticizer is DOA, the gel composition may contain 200 parts by mass or more and 800 parts by mass or less, preferably 250 parts by mass or more and 600 parts by mass or less, of the plasticizer with respect to 100 parts by mass of the polyvinyl chloride-based resin. The gel composition may contain 300 parts by mass or more of the plasticizer with respect to the polyvinyl chloride-based resin. This makes it possible to obtain the gel composition having a relatively large degree of inverse piezoelectric effect and a large degree of tackiness.

When the plasticizer is DINA, the gel composition may contain 200 parts by mass or more and 800 parts by mass or less, preferably 250 parts by mass or more and 600 parts by mass or less, of the plasticizer with respect to 100 parts by mass of the polyvinyl chloride-based resin. The gel composition may contain 300 parts by mass or more of the plasticizer with respect to the polyvinyl chloride-based resin. This makes it possible to obtain the gel composition having a relatively large degree of inverse piezoelectric effect and a large degree of tackiness.

(Other additives) Although 100 mass% of the above-described two-component system of polyvinyl chloride and plasticizer in the composition is preferable, any additive including other solvents in an amount of 20 mass% or less may be blended.

### (B. Physical properties of gel composition)

### (Degree of inverse piezoelectric effect)

As described above, the gel composition containing the above plasticizer is a piezoelectric material, and the actuator and/or the sensor can be implemented by utilizing the inverse piezoelectric effect and/or piezoelectric effect of the gel composition. The degree of inverse piezoelectric effect of the gel composition can be evaluated, for example, by a deformation amount (µm) of a sample measured by the following procedure.

According to the present embodiment, first, a sample having a height of 1.5 cm, a width of 1.5 cm, and a thickness of 0.03 cm is cut out from a gel composition to be measured. Next, as a cathode, a tape-shaped electrode made of aluminum having a height of 7.5 cm, a width of 2.5 cm, and a thickness of 0.008 cm is prepared. Similarly, as an anode, a mesh-shaped electrode made of stainless steel having a wire diameter of 0.18 mm, an opening size of 0.67 mm, and an aperture ratio of 62% is prepared.

Next, the cathode is placed on a smooth measurement table arranged horizontally. Also, the sample is placed on the cathode, and an anode mesh and an aluminum tape are slowly placed on the sample. Next, using a laser displacement meter (manufactured by Keyence Corporation, model LK-G30), a distance between a laser sensor and the aluminum tape on the anode mesh in a state in which no voltage is applied to the anode and the cathode is measured.

Next, using a voltage application device (manufactured by Matsusada Precision Inc., model HARb-1P30-LFPs), voltage is applied to the anode and the cathode. A magnitude of the voltage to be applied is, for example, 100 V or 300 V. Also, using the laser displacement meter (manufactured by Keyence Corporation, model LK-G30), a distance between the laser sensor and the aluminum tape on the anode mesh in a state in which voltage is applied to the anode and the cathode is measured.

Next, a difference in thickness of the sample before and after the voltage is applied to the anode and the cathode is calculated. Thus, an amount of deformation (µm) of the sample before and after the voltage (as described above, for example, 100 V or 300 V) is applied to the anode and the cathode is derived.

When a voltage of 300 V is applied to the sample having a height of 1.5 cm, a width of 1.5 cm, and a thickness of 0.03 cm, using, as the anode, the stainless-steel mesh electrode having a wire diameter of 0.18 mm, an opening size of 0.67 mm, and an aperture ratio of 62%, a displacement of the sample is, for example, 0.5 µm or more. The above displacement may be 10 µm or more, and is preferably 20 µm or more. Thus, for example, the actuator with low power consumption and/or the sensor with good sensitivity or the like can be realized.

### (Degree of tackiness)

As described above, the gel composition containing the plasticizer has the relatively large tackiness. The degree of tackiness of the gel composition can be evaluated by, for example, a tack force measured by the following procedure.

According to the present embodiment, first, the sample having a height of 1.5 cm, a width of 1.5 cm, and a thickness of 0.03 cm is cut out from the gel composition to be measured. Next, as the cathode, an aluminum tape-shaped electrode having a height of 2 cm, a width of 3.5 cm, and a thickness of 0.009 cm is prepared. Similarly, as the anode, the aluminum electrode is prepared.

Next, the anode is attached to a detection unit of a load cell (manufactured by Kyowa Electronic Instruments Co., Ltd., model LTS-500GA). Also, the cathode is placed on the smooth measurement table arranged horizontally, and the sample is placed on the cathode. Thereafter, a distance between the anode attached to the detection unit and the sample is adjusted, and the anode is slowly placed on the sample. The load cell is attached to a Z-axis lifting/lowering stage (Chuo Precision Industrial Co., Ltd., ALV104-HP), and a distance to the sample is adjusted by lifting and lowering the Z-axis lifting/lowering stage.

Next, using the voltage application device (manufactured by Matsusada Precision Inc., model HARb-1P30-LFPs), voltage is applied to the anode and the cathode. A magnitude of the voltage to be applied is, for example, 100 V or 300 V.

Next, the load cell is slowly raised. The load cell is raised until the sample is peeled off from the anode, and a force pulling the load cell at a time of peeling is measured. Similarly, the force pulling the load cell at a time when the sample is peeled off from the anode at an applied voltage of 0 V is measured as an adhesive force. A difference between a value of the pulling force at each applied voltage and the pulling force at 0 V is derived as the tack force.

In a state in which a voltage of 300 V is applied to the sample having a height of 1.5 cm, a width of 1.5 cm, and a thickness of 0.03 cm, with the aluminum electrode as the anode, the tack force measured as a force required to peel the sample in contact from the anode is, for example, 0.5 N/cm² or more. The above tack force may be 1 N/cm² or more, and is preferably 2 N/cm² or more. This can realize, for example, the actuator with low power consumption, and/or the sensor with good sensitivity or the like.

A product of the displacement (µm) of the above sample and the tack force (N/cm²), when measured at 300 V, may be 20 µm·N/cm² or more, preferably may be 36 µm·N/cm² or more, and more preferably may be 50 µm·N/cm² or more. When measured at 100 V, the product may be 0.3 µm·N/cm² or more, preferably may be 1.3 µm·N/cm² or more, and more preferably may be 2.0 µm·N/cm² or more. This makes it possible, for example, to increase both the degree of the inverse piezoelectric effect of the gel composition and the tack force in a well-balanced manner without being biased toward one. As a result, it is possible to realize, for example, the actuator with low power consumption, and/or the sensor with good sensitivity. Note that the requirement for the product of the displacement (µm) and the tack force (N/cm²) is an example of a more preferable embodiment and is not an essential requirement.

The displacement/tack force obtained by dividing the displacement (µm) of the above sample by the tack force (N/cm²), when measured at 300 V, may be 0.4 µm·cm²/N or more, preferably may be 1.5 µm·cm²/N or more, and more preferably may be 3.0 µm·cm²/N or more. When measured at 100 V, the displacement/tack force may be 0.5 µm·cm²/N or more, preferably may be 1.5 µm·cm²/N or more, and more preferably may be 3.0 µm·cm²/N or more. This makes it possible, for example, to increase the displacement per tack force and to increase the inverse piezoelectric effect when the tack force is adjusted to be constant. As a result, it is possible to realize, for example, the actuator with low power consumption, and/or the sensor with good sensitivity. Note that the requirement for the ratio of the displacement (µm)/tack force (N/cm²) is an example of a more preferable embodiment and is not an essential requirement.

### (C. Method for manufacturing gel composition)

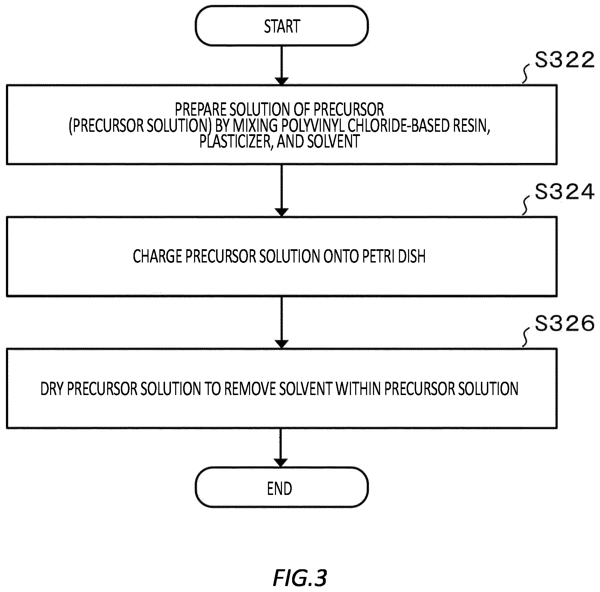

With reference to FIG. 3, details of a method for preparing the polymer layer 116 (more specifically, the gel composition) will be described. FIG. 3 schematically illustrates an example of the method for preparing the polymer layer 116.

### (Solution casting method)

According to an embodiment shown in FIG. 3, first, in step 322 (the step may be abbreviated as S), a polyvinyl chloride-based resin, a plasticizer, and a solvent are mixed. Thus, a mixture of the polyvinyl chloride-based resin, the plasticizer, and the solvent (which may be referred to as a precursor solution) is obtained.

Examples of the solvent include cyclic ether compounds, cyclic ketone compounds, and the like. Examples of the cyclic ether compounds include tetrahydrofuran (THF), dioxane, and the like. Examples of the cyclic ketone compounds include cyclohexanone and the like.

The precursor solution includes, for example, 100 parts by mass or more and 1000 parts by mass or less of the plasticizer with respect to 100 parts by mass of the polyvinyl chloride-based resin.

The precursor solution includes, for example, 1000 parts by mass or more and 3000 parts by mass or less of the solvent with respect to 100 parts by mass of the polyvinyl chloride-based resin. The precursor solution may contain 1500 parts by mass or more and 2500 parts by mass or less of the solvent with respect to 100 parts by mass of the polyvinyl chloride-based resin. At this time, it is preferable to perform stirring for about 1 hour to about 2 weeks, preferably for 12 hours to 10 days, if necessary, since this allows the polyvinyl chloride-based resin and the plasticizer to be uniformly mixed. Further, the stirring is not particularly limited as long as conditions allow uniform mixing, but it is preferable to perform stirring at 50 to 2000 rpm, preferably 100 to 1000 rpm.

Next, in S324, the precursor solution is charged onto an appropriate Petri dish so as to have a desired thickness. Next, in S326, a drying step of the precursor solution is performed. Thus, a part of the solvent is removed from the precursor solution described above. The drying step is performed, for example, at a temperature of 5°C or higher and 35°C or lower. The drying step can form a gel-like polymer formation member by being performed, for example, for 1 day or more, preferably for about 1 week or more and about 3 weeks, at the temperature described above. A thickness of the member may be appropriately adjusted according to the purpose, but is preferably 0.01 to 0.1 cm.

In the drying step described above, gelation proceeds, and a gel composition containing the polyvinyl chloride-based resin and the plasticizer is obtained. A ratio of a mass of the solvent to a mass of the gel composition after drying may be 1 mass% or less, and may be less than 0.1 mass%.

In the present embodiment, an example of a method for producing the gel composition has been described, taking as an example a case where S322 is performed using a polyvinyl chloride-based resin prepared in advance. However, the method for producing the gel composition is not limited to the present embodiment. In another embodiment, before S322 is performed, a step of removing at least a part of impurities contained in the polyvinyl chloride-based resin may be further performed. Examples of the impurities described above include the unavoidable impurities described above. In this case, in S322, the precursor solution is prepared by mixing the polyvinyl chloride-based resin from which the impurities have been removed, the plasticizer, and the solvent.

A ratio of a total mass of the polyvinyl chloride-based resin and the plasticizer to a mass of the mixture described above may be 80 mass% or more, and may be 90 mass% or more. The ratio of the total mass of the polyvinyl chloride-based resin and the plasticizer to the mass of the mixture described above may be 80 mass% or more and 100 mass% or less.

### EXAMPLES

Hereinafter, examples are shown, and the present invention is specifically described. Note that the present invention is not limited to the following manufacturing examples, synthesis examples, or examples. Further, unless otherwise specified, "parts" represent "parts by mass", and "%" represents "mass%".

### (Example 1)

First, 30 g of tetrahydrofuran (THF; manufactured by FUJIFILM Wako Pure Chemical Corporation, special grade 204-08745, purity 99.5%) and 4 g of di-2-ethylhexyl isophthalate (DOIP; manufactured by CG Ester Co., Ltd., product name DOIP, purity 99% or more) were charged into a reaction vessel. While stirring THF and DOIP under a condition of 500 rpm using a magnetic stirrer, 2 g of polyvinyl chloride (PVC; manufactured by Shin-Etsu Chemical Co., Ltd., product name TK-2500HS, K value 84.4, purity 99.5% or more) was added little by little. Thereafter, under conditions of 500 rpm, a mixed solution of THF, DOIP, and PVC was stirred for one week.

Next, the above mixed solution was charged into a Petri dish having a diameter of 7.6 cm. The above Petri dish was allowed to stand for two weeks at a temperature of 5°C or higher and 35°C or lower. Thus, a gel composition having a diameter of 7.6 cm and a thickness of 0.3 mm was obtained.

### (Examples 2 to 4)

A gel composition was prepared in accordance with a same procedure as in Example 1, except for differences in an added amount of the plasticizer and/or an added amount of THF. Tables 1 to 4 (also collectively referred to as "Table 1 and the like") show the added amounts of PVC, the plasticizer, and THF in each example.

### (Example 5)

A gel composition was prepared in accordance with the same procedure as in Example 1, except that di-2-ethylhexyl terephthalate (DOTP; manufactured by ADEKA Corporation, product name: ADEKA CIZER D-810, purity: 99% or higher) was used as the plasticizer. Table 1 and the like show the added amounts of PVC, the plasticizer, and THF in Example 5.

### (Examples 6 to 9)

A gel composition was prepared in accordance with a same procedure as in Example 5, except for differences in the added amount of the plasticizer and/or the added amount of THF. Table 1 and the like show the added amounts of PVC, the plasticizer, and THF in each example.

### (Example 10)

A gel composition was prepared in accordance with the same procedure as in Example 1, except that dibutyl fumarate (DBF; manufactured by Tokyo Chemical Industry Co., Ltd., product code F0116, purity: 98% or higher) was used as the plasticizer, and except for differences in the added amounts of PVC, the plasticizer, and THF. Table 1 and the like show the added amounts of PVC, the plasticizer, and THF in Example 10.

### (Examples 11 to 13)

A gel composition was prepared in accordance with a same procedure as in Example 10, except for differences in the added amount of the plasticizer and/or the added amount of THF. Table 1 and the like show the added amounts of PVC, the plasticizer, and THF in each example.

### (Example 14)

A gel composition was prepared in accordance with the same procedure as in Example 1, except that di-2-ethylhexyl fumarate (DOF; manufactured by Tokyo Chemical Industry Co., Ltd., product code F0117, purity: 98% or higher) was used as the plasticizer, and except for differences in the added amounts of PVC, the plasticizer, and THF. Table 1 and the like show the added amounts of PVC, the plasticizer, and THF in Example 14.

### (Examples 15 to 18)

A gel composition was prepared in accordance with a same procedure as in Example 14, except for differences in the added amount of the plasticizer and/or the added amount of THF. Table 1 and the like show the added amounts of PVC, the plasticizer, and THF in each example.

### (Example 19)

A gel composition was prepared in accordance with the same procedure as in Example 1, except that methyl acetyl ricinoleate (MAR; manufactured by Tokyo Chemical Industry Co., Ltd., product code A0879, purity 80% or more) was used as the plasticizer and except for differences in the added amounts of PVC, the plasticizer, and THF. Table 1 and the like show the added amounts of PVC, the plasticizer, and THF in Example 19.

### (Examples 20 to 22)

A gel composition was prepared in accordance with a same procedure as in Example 19, except for differences in the added amount of the plasticizer and/or the added amount of THF. Table 1 and the like show the added amounts of PVC, the plasticizer, and THF in each example.

### (Example 23)

A gel composition was prepared in accordance with the same procedure as in Example 1, except that acetyl tributyl citrate (ATBC; manufactured by Taoka Chemical Co., Ltd., product name ATBC, purity 99% or more) was used as the plasticizer and except for differences in the added amounts of PVC, the plasticizer, and THF. Table 1 and the like show the added amounts of PVC, the plasticizer, and THF in Example 23.

### (Examples 24 to 26)

A gel composition was prepared in accordance with a same procedure as in Example 23, except for differences in the added amount of the plasticizer and/or the added amount of THF. Table 1 and the like show the added amounts of PVC, the plasticizer, and THF in each example.

### (Example 27)

A gel composition was prepared in accordance with the same procedure as in Example 1, except that diethyl fumarate (DEF; manufactured by Tokyo Chemical Industry Co., Ltd., product code F0068, purity 98% or more) was used as the plasticizer and except for differences in the added amounts of PVC, the plasticizer, and THF. Table 1 and the like show the added amounts of PVC, the plasticizer, and THF in Example 27.

### (Examples 28 to 30)

A gel composition was prepared in accordance with a same procedure as in Example 27, except for differences in the added amount of the plasticizer and/or the added amount of THF. Table 1 and the like show the added amounts of PVC, the plasticizer, and THF in each example.

### (Example 31)

A gel composition was prepared in accordance with the same procedure as in Example 1, except that diethyl maleate (DEM; manufactured by Tokyo Chemical Industry Co., Ltd., product code M0010, purity 90% or more) was used as the plasticizer and except for differences in the added amounts of PVC, the plasticizer, and THF. Table 1 and the like show the added amounts of PVC, the plasticizer, and THF in Example 31.

### (Examples 32 to 34)

A gel composition was prepared in accordance with a same procedure as in Example 31, except for differences in the added amount of the plasticizer and/or the added amount of THF. Table 1 and the like show the added amounts of PVC, the plasticizer, and THF in each example.

### (Example 35)

A gel composition was prepared in accordance with the same procedure as in Example 1, except that dibutyl maleate (DBM; manufactured by Tokyo Chemical Industry Co., Ltd., product code M0009, purity 95% or more) was used as the plasticizer and except for differences in the added amounts of PVC, the plasticizer, and THF. Table 1 and the like show the added amounts of PVC, the plasticizer, and THF in Example 35.

### (Examples 36 to 38)

A gel composition was prepared in accordance with a same procedure as in Example 35, except for differences in the added amount of the plasticizer and/or the added amount of THF. Table 1 and the like show the added amounts of PVC, the plasticizer, and THF in each example.

### (Example 39)

A gel composition was prepared in accordance with the same procedure as in Example 1, except that triethyl citrate (TEC; manufactured by Tokyo Chemical Industry Co., Ltd., product code C0367, purity 99% or more) was used as the plasticizer and except for differences in the added amounts of PVC, the plasticizer, and THF. Table 1 and the like show the added amounts of PVC, the plasticizer, and THF in Example 39.

### (Examples 40 to 42)

A gel composition was prepared in accordance with a same procedure as in Example 39, except for differences in the added amount of the plasticizer and/or the added amount of THF. Table 1 and the like show the added amounts of PVC, the plasticizer, and THF in each example.

### (Example 43)

A gel composition was prepared in accordance with the same procedure as in Example 1, except that tributyl citrate (TBC; manufactured by Tokyo Chemical Industry Co., Ltd., product code C0366, purity 98% or more) was used as the plasticizer and except for differences in the added amounts of PVC, the plasticizer, and THF. Table 1 and the like show the added amounts of PVC, the plasticizer, and THF in Example 43.

### (Examples 44 to 46)

A gel composition was prepared in accordance with a same procedure as in Example 43, except for differences in the added amount of the plasticizer and/or the added amount of THF. Table 1 and the like show the added amounts of PVC, the plasticizer, and THF in each example.

### (Example 47)

A gel composition was prepared in accordance with the same procedure as in Example 1, except that di-2-ethylhexyl adipate (DOA; manufactured by Tokyo Chemical Industry Co., Ltd., product code A0163, purity 98% or more) was used as the plasticizer and except for differences in the added amounts of PVC, the plasticizer, and THF. Table 1 and the like show the added amounts of PVC, the plasticizer, and THF in Example 47.

### (Examples 48 to 51)

A gel composition was prepared in accordance with a same procedure as in Example 47, except for differences in the added amount of the plasticizer and/or the added amount of THF. Table 1 and the like show the added amounts of PVC, the plasticizer, and THF in each example.

### (Example 52)

A gel composition was prepared in accordance with the same procedure as in Example 1, except that diisononyl adipate (DINA; manufactured by Shin-Nippon Rika Co., Ltd., product name SANSO CIZER DINA, purity 99% or more) was used as the plasticizer and except for differences in the added amounts of PVC, the plasticizer, and THF. Table 1 and the like show the added amounts of PVC, the plasticizer, and THF in Example 52.

### (Examples 53 to 56)

A gel composition was prepared in accordance with a same procedure as in Example 52, except for differences in the amount of the plasticizer added and/or the amount of THF added. Table 1 and the like show the added amounts of PVC, the plasticizer, and THF in each example.

### (Example 57)

A gel composition was prepared in accordance with the same procedure as in Example 1, except that TK-2500PE (manufactured by Shin-Etsu Chemical Co., Ltd.; K value = 88) was used as PVC, dibutyl fumarate (DBF; manufactured by Tokyo Chemical Industry Co., Ltd., product code F0116, purity 98% or more) was used as the plasticizer, and except for differences in the amount of the plasticizer added and/or the amount of THF added. Tables 5 and 6 (also collectively referred to as "Table 5 and the like") show the amounts of PVC, the plasticizer, and THF added in Example 57.

### (Examples 58 to 60)

A gel composition was prepared in accordance with a same procedure as in Example 57, except for differences in the amounts of PVC, the plasticizer, and/or THF added. Table 5 and the like show the added amounts of PVC, the plasticizer, and THF in each example.

### (Example 61)

A gel composition was prepared in accordance with the same procedure as in Example 1, except that VICIR S5000 (manufactured by Cires; K value 99) was used as PVC, dibutyl fumarate (DBF; manufactured by Tokyo Chemical Industry Co., Ltd., product code F0116, purity 98% or more) was used as the plasticizer, and except for differences in the amount of the plasticizer added and/or the amount of THF added. Table 5 and the like show the added amounts of PVC, the plasticizer, and THF in Example 61.

### (Examples 62 to 64)

A gel composition was prepared in accordance with a same procedure as in Example 61, except for differences in the amounts of PVC, the plasticizer, and/or THF added. Table 5 and the like show the added amounts of PVC, the plasticizer, and THF in each example.

### (Comparative Example 1)

A gel composition was prepared in accordance with the same procedure as in Example 1, except that di-2-ethylhexyl phthalate (DOP; manufactured by CG Ester Co., Ltd., product name DOP, purity 99% or more) was used as the plasticizer. Table 1 and the like show the added amounts of PVC, the plasticizer, and THF in Comparative Example 1.

### (Comparative Examples 2 to 4)

A gel composition was prepared in accordance with a same procedure as in Comparative Example 1, except for differences in the amount of the plasticizer added and/or the amount of THF added. Table 1 and the like show the added amounts of PVC, the plasticizer, and THF in each comparative example.

### (Comparative Example 5)

A gel composition was prepared in accordance with the same procedure as in Example 1, except that dibutyl adipate (DBA; manufactured by FUJIFILM Wako Pure Chemical Corporation, special grade 043-19421, purity 99%) was used as the plasticizer. Table 1 and the like show the added amounts of PVC, the plasticizer, and THF in Comparative Example 5.

### (Comparative Examples 6 to 8)

A gel composition was prepared in accordance with a same procedure as in Comparative Example 5, except for differences in the added amount of the plasticizer and/or the added amount of THF. Table 1 and the like show the added amounts of PVC, the plasticizer, and THF in each comparative example.

### (Evaluation)

For the gel compositions prepared in each of the examples and each of the comparative examples, the above-described displacement and tack force were measured. For each of a case where a voltage of 100 V is applied to the gel composition and a case where a voltage of 300 V is applied to the gel composition, the above displacement and tack force were measured. Table 1 and the like show the displacement and tack force of each example and each comparative example in a case where the voltage of 100 V is applied to the gel composition, and the displacement and tack force of each example and each comparative example in a case where the voltage of 300 V is applied to the gel composition.

According to Examples 1 to 26, it can be understood that, when the plasticizer is at least one selected from a group consisting of isophthalic acid esters, terephthalic acid esters, fumaric acid esters, acetyl ricinoleic acid esters, acetyl citric acid esters and derivatives thereof, and salts thereof, the gel composition containing the plasticizer and the polyvinyl chloride-based resin is the piezoelectric material. It can also be understood that the gel composition described above has the excellent tackiness.

Further, when Examples 1 to 9 are compared with Comparative Examples 1 to 4, it can be understood that, when the plasticizer is di-2-ethylhexyl isophthalate (DOIP) and/or di-2-ethylhexyl terephthalate (DOTP), the gel composition having a higher degree of tackiness can be obtained as compared with the gel composition containing, as the plasticizer, di-2-ethylhexyl phthalate (DOP), which is a structural isomer of these compounds. It can also be understood that, in a gel composition containing DOTP as the plasticizer, as the added amount of the plasticizer increases, the degree of the inverse piezoelectric effect of the gel composition increases, and the degree of tackiness of the gel composition also increases. Furthermore, it can be understood that, when DOTP is used as a plasticizer, the gel composition having a relatively high degree of the inverse piezoelectric effect and having a relatively high degree of tackiness can be obtained.

When Examples 10 to 56 are compared with Comparative Examples 5 to 8, it can be understood that, when the plasticizer is dibutyl fumarate (DBF), di-2-ethylhexyl fumarate (DOF), methyl acetyl ricinoleate (MAR), acetyl tributyl citrate (ATBC), diethyl fumarate (DEF), diethyl maleate (DEM), dibutyl maleate (DBM), triethyl citrate (TEC), tributyl citrate (TBC), di-2-ethylhexyl adipate (DOA), and/or diisononyl adipate (DINA), the gel composition having a high degree of tackiness can be obtained. It can also be understood that the gel composition described above has a relatively high degree of the inverse piezoelectric effect and has a high degree of tackiness, as compared with a case where the plasticizer is the dibutyl adipate (DBA).

When Examples 5 to 56 are compared with Comparative Examples 1 to 8, it can be understood that, when the plasticizer is di-2-ethylhexyl terephthalate (DOTP), dibutyl fumarate (DBF), di-2-ethylhexyl fumarate (DOF), methyl acetyl ricinoleate (MAR), acetyl tributyl citrate (ATBC), diethyl fumarate (DEF), diethyl maleate (DEM), dibutyl maleate (DBM), triethyl citrate (TEC), tributyl citrate (TBC), di-2-ethylhexyl adipate (DOA), and/or diisononyl adipate (DINA), the gel composition having a large value (particularly when 300 V is applied) obtained by multiplying the degree of the inverse piezoelectric effect and the degree of tackiness can be obtained.

**Table 1**

| No | PLASTICIZER | RAW MATERIAL | | | COMPOSITION RATIO |
|---|---|---|---|---|---|
| | | PVC (g) | PLASTICIZER (g) | THF (g) | PVC:PLASTICIZER |
| COMPARATIVE EXAMPLE 1 | DI-2-ETHYLHEXYL PHTHALATE (DOP) | 2 | 4 | 30 | 1 : 2 |
| COMPARATIVE EXAMPLE 2 | | 2 | 6 | 30 | 1 : 3 |
| COMPARATIVE EXAMPLE 3 | | 2 | 8 | 35 | 1 : 4 |
| COMPARATIVE EXAMPLE 4 | | 2 | 10 | 35 | 1 : 5 |
| COMPARATIVE EXAMPLE 5 | DIBUTYL ADIPATE (DBA) | 2 | 4 | 30 | 1 : 2 |
| COMPARATIVE EXAMPLE 6 | | 2 | 6 | 30 | 1 : 3 |
| COMPARATIVE EXAMPLE 7 | | 2 | 8 | 35 | 1 : 4 |
| COMPARATIVE EXAMPLE 8 | | 2 | 10 | 35 | 1 : 5 |
| EXAMPLE 1 | DI-2-ETHYLHEXYL ISOPHTHALATE (DOIP) | 2 | 4 | 30 | 1 : 2 |
| EXAMPLE 2 | | 2 | 6 | 30 | 1 : 3 |
| EXAMPLE 3 | | 2 | 8 | 35 | 1 : 4 |
| EXAMPLE 4 | | 2 | 10 | 35 | 1 : 5 |
| EXAMPLE 5 | DI-2-ETHYLHEXYL TEREPHTHALATE (DOTP) | 2 | 4 | 30 | 1 : 2 |
| EXAMPLE 6 | | 2 | 6 | 30 | 1 : 3 |
| EXAMPLE 7 | | 2 | 8 | 35 | 1 : 4 |
| EXAMPLE 8 | | 2 | 10 | 35 | 1 : 5 |
| EXAMPLE 9 | | 2 | 12 | 45 | 1 : 6 |
| EXAMPLE 10 | DIBUTYL FUMARATE (DBF) | 3 | 6 | 40 | 1 : 2 |
| EXAMPLE 11 | | 2 | 6 | 40 | 1 : 3 |
| EXAMPLE 12 | | 2 | 8 | 45 | 1 : 4 |
| EXAMPLE 13 | | 2 | 10 | 45 | 1 : 5 |
| EXAMPLE 14 | DI-2-ETHYLHEXYL FU MARATE (DOF) | 3 | 6 | 40 | 1 : 2 |
| EXAMPLE 15 | | 2 | 6 | 40 | 1 : 3 |
| EXAMPLE 16 | | 2 | 8 | 45 | 1 : 4 |
| EXAMPLE 17 | | 2 | 10 | 45 | 1 : 5 |
| EXAMPLE 18 | | 2 | 12 | 45 | 1 : 6 |
| EXAMPLE 19 | METHYL ACETYL RICINOLEATE (MAR) | 3 | 6 | 40 | 1 : 2 |
| EXAMPLE 20 | | 2 | 6 | 40 | 1 : 3 |
| EXAMPLE 21 | | 2 | 8 | 45 | 1 : 4 |
| EXAMPLE 22 | | 2 | 10 | 45 | 1 : 5 |
| EXAMPLE 23 | ACETYL TRIBUTYL CITRATE (ATBC) | 3 | 6 | 40 | 1 : 2 |
| EXAMPLE 24 | | 2 | 6 | 30 | 1 : 3 |
| EXAMPLE 25 | | 2 | 8 | 35 | 1 : 4 |
| EXAMPLE 26 | | 2 | 10 | 35 | 1 : 5 |

**Table 2**

| No | PLASTICIZER | RAW MATERIAL | | | COMPOSITION RATIO |
|---|---|---|---|---|---|
| | | PVC (g) | PLASTICIZER (g) | THF (g) | PVC: PLASTICIZER |
| EXAMPLE 27 | DIETHYL FUMARATE (DEF) | 2 | 4 | 60 | 1 : 2 |
| EXAMPLE 28 | | 2 | 6 | 60 | 1 : 3 |
| EXAMPLE 29 | | 2 | 8 | 60 | 1 : 4 |
| EXAMPLE 30 | | 2 | 10 | 60 | 1 : 5 |
| EXAMPLE 31 | DIETHYL MALEATE (DEM) | 2 | 4 | 60 | 1 : 2 |
| EXAMPLE 32 | | 2 | 6 | 60 | 1 : 3 |
| EXAMPLE 33 | | 2 | 8 | 60 | 1 : 4 |
| EXAMPLE 34 | | 2 | 10 | 60 | 1 : 5 |
| EXAMPLE 35 | DIBUTYL MALEATE (DBM) | 2 | 4 | 60 | 1 : 2 |
| EXAMPLE 36 | | 2 | 6 | 60 | 1 : 3 |
| EXAMPLE 37 | | 2 | 8 | 60 | 1 : 4 |
| EXAMPLE 38 | | 2 | 10 | 60 | 1 : 5 |
| EXAMPLE 39 | TRIETHYL CITRATE (TEC) | 2 | 4 | 60 | 1 : 2 |
| EXAMPLE 40 | | 2 | 6 | 60 | 1 : 3 |
| EXAMPLE 41 | | 2 | 8 | 60 | 1 : 4 |
| EXAMPLE 42 | | 2 | 10 | 60 | 1 : 5 |
| EXAMPLE 43 | TRIBUTYL CITRATE (TBC) | 2 | 4 | 60 | 1 : 2 |
| EXAMPLE 44 | | 2 | 6 | 60 | 1 : 3 |
| EXAMPLE 45 | | 2 | 8 | 60 | 1 : 4 |
| EXAMPLE 46 | | 2 | 10 | 60 | 1 : 5 |
| EXAMPLE 47 | DI-2-ETHYLHEXYL ADIPATE (DOA) | 2 | 4 | 60 | 1 : 2 |
| EXAMPLE 48 | | 2 | 6 | 60 | 1 : 3 |
| EXAMPLE 49 | | 2 | 8 | 60 | 1 : 4 |
| EXAMPLE 50 | | 2 | 10 | 60 | 1 : 5 |
| EXAMPLE 51 | | 2 | 12 | 60 | 1 : 6 |
| EXAMPLE 52 | DIISONONYL ADIPATE (DINA) | 2 | 4 | 60 | 1 : 2 |
| EXAMPLE 53 | | 2 | 6 | 60 | 1 : 3 |
| EXAMPLE 54 | | 2 | 8 | 60 | 1 : 4 |
| EXAMPLE 55 | | 2 | 10 | 60 | 1 : 5 |
| EXAMPLE 56 | | 2 | 12 | 60 | 1 : 6 |

**Table 3**

| No | PHYSICAL PROPERTIES UNDER 300 V APPLICATION | | | | PHYSICAL PROPERTIES UNDER 100 V APPLICATION | | | |
|---|---|---|---|---|---|---|---|---|
| | DISPLACEMENT (µm) | TACK FORCE (N/cm²) | TACK FORCE x DISPLACEMENT (µ mN/cm²) | DISPLACEMENT /ACK FORCE (µ mcm²/N) | DISPLACEMENT (µm) | TACK FORCE (N/cm²) | TACK FORCE x DISPLACEMENT (µ mN/cm²) | DISPLACEMENT /TACK FORCE (µ mcm²/N) |
| COMPARATIVE EXAMPLE 1 | 1.0 | 1.3 | 1.3 | 0.8 | 0.7 | 0.1 | 0.1 | 7.0 |
| COMPARATIVE EXAMPLE 2 | 13.3 | 0.9 | 12.2 | 14.5 | 1.5 | 0.1 | 0.2 | 13.6 |
| COMPARATIVE EXAMPLE 3 | 20.1 | 0.3 | 5.8 | 69.3 | 3.0 | 0.1 | 0.2 | 50.0 |
| COMPARATIVE EXAMPLE 4 | 23.0 | 0.3 | 7.1 | 74.2 | 4.7 | 0.0 | 0.0 | - |
| COMPARATIVE EXAMPLE 5 | 12.4 | 2.8 | 35.0 | 4.4 | 1.7 | 0.6 | 1.0 | 3.0 |
| COMPARATIVE EXAMPLE 6 | 9.1 | 0.4 | 3.7 | 22.2 | 1.2 | 0.1 | 0.1 | 20.0 |
| COMPARATIVE EXAMPLE 7 | 31.2 | 0.4 | 10.9 | 89.1 | 5.4 | 0.0 | 0.0 | - |
| COMPARATIVE EXAMPLE 8 | 31.9 | 1.0 | 31.3 | 32.6 | 6.8 | 0.2 | 1.2 | 37.8 |
| EXAMPLE 1 | 0.7 | 1.9 | 1.3 | 0.4 | 0.3 | 0.4 | 0.1 | 0.8 |
| EXAMPLE 2 | 6.0 | 1.9 | 11.5 | 3.1 | 0.9 | 0.4 | 0.4 | 2.2 |
| EXAMPLE 3 | 10.9 | 1.2 | 13.3 | 8.9 | 2.0 | 0.1 | 0.2 | 18.2 |
| EXAMPLE 4 | 14.9 | 1.0 | 15.0 | 14.8 | 3.3 | 0.1 | 0.4 | 25.4 |
| EXAMPLE 5 | 0.6 | 1.4 | 0.9 | 0.4 | 0.0 | 0.3 | 0.0 | 0.0 |
| EXAMPLE 6 | 4.5 | 2.4 | 10.6 | 1.9 | 0.8 | 0.5 | 0.4 | 1.7 |
| EXAMPLE 7 | 11.8 | 2.5 | 29.9 | 4.7 | 2.3 | 0.7 | 1.5 | 3.5 |
| EXAMPLE 8 | 20.0 | 2.5 | 49.2 | 8.1 | 4.5 | 0.5 | 2.4 | 8.3 |
| EXAMPLE 9 | 24.9 | 2.0 | 48.6 | 12.8 | 8.3 | 0.3 | 2.7 | 25.2 |
| EXAMPLE 10 | 6.0 | 2.8 | 17.0 | 2.1 | 1.5 | 0.5 | 0.7 | 3.1 |
| EXAMPLE 11 | 11.4 | 2.5 | 28.3 | 4.8 | 2.3 | 0.3 | 0.6 | 8.8 |
| EXAMPLE 12 | 14.5 | 2.2 | 31.7 | 6.7 | 3.3 | 0.7 | 2.3 | 4.8 |
| EXAMPLE 13 | 25.0 | 2.0 | 51.0 | 12.3 | 4.9 | 0.6 | 2.9 | 8.3 |
| EXAMPLE 14 | 6.2 | 3.7 | 22.7 | 1.7 | 1.2 | 0.3 | 0.3 | 4.8 |
| EXAMPLE 15 | 17.5 | 2.9 | 51.3 | 6.0 | 3.1 | 0.9 | 2.9 | 3.3 |
| EXAMPLE 16 | 15.7 | 2.6 | 41.3 | 6.0 | 4.0 | 0.4 | 1.6 | 10.0 |
| EXAMPLE 17 | 26.1 | 2.7 | 70.7 | 9.6 | 6.2 | 0.7 | 4.2 | 9.3 |
| EXAMPLE 18 | 40.4 | 2.4 | 94.9 | 17.2 | 10.6 | 0.9 | 10.0 | 11.3 |
| EXAMPLE 19 | 10.2 | 3.9 | 39.8 | 2.5 | 1.6 | 0.3 | 0.5 | 5.0 |
| EXAMPLE 20 | 15.0 | 3.3 | 50.1 | 4.5 | 3.4 | 1.3 | 4.5 | 2.6 |
| EXAMPLE 21 | 15.7 | 3.3 | 52.4 | 4.7 | 4.4 | 0.5 | 2.0 | 9.6 |
| EXAMPLE 22 | 20.0 | 3.0 | 60.8 | 6.6 | 5.2 | 0.8 | 4.4 | 6.2 |
| EXAMPLE 23 | 5.0 | 3.0 | 14.8 | 1.7 | 1.1 | 0.5 | 0.5 | 2.3 |
| EXAMPLE 24 | 32.2 | 1.1 | 36.1 | 28.8 | 4.3 | 0.0 | 0.0 | - |
| EXAMPLE 25 | 33.1 | 1.5 | 50.6 | 21.6 | 3.5 | 0.1 | 0.4 | 31.8 |
| EXAMPLE 26 | 36.5 | 0.9 | 33.2 | 40.1 | 7.0 | 0.0 | 0.0 | - |

**Table 4**

| No | PHYSICAL PROPERTIES UNDER 300 V APPLICATION | | | | PHYSICAL PROPERTIES UNDER 100 V APPLICATION | | | |
|---|---|---|---|---|---|---|---|---|
| | DISPLACEMENT (µm) | TACK FORCE (N/cm²) | TACK FORCE x DISPLACEMENT (µ mN/cm²) | DISPLACEMENT /TACK FORCE (µ mcm²/N) | DISPLACEMENT (µm) | TACK FORCE (N/cm²) | TACK FORCE x DISPLACEMENT (µ mN/cm²) | DISPLACEMENT /TACK FORCE (µ mcm²/N) |
| EXAMPLE 27 | 5.4 | 2.8 | 15.1 | 1.9 | 1.0 | 1.2 | 1.2 | 0.8 |
| EXAMPLE 28 | 3.0 | 5.9 | 17.7 | 0.5 | 0.8 | 1.8 | 1.4 | 0.5 |
| EXAMPLE 29 | 16.5 | 2.3 | 38.4 | 7.1 | 2.2 | 0.8 | 1.7 | 2.8 |
| EXAMPLE 30 | 9.9 | 1.9 | 18.4 | 5.3 | 1.7 | 0.7 | 1.1 | 2.5 |
| EXAMPLE 31 | 12.4 | 4.7 | 58.3 | 2.6 | 2.2 | 2.1 | 4.6 | 1.1 |
| EXAMPLE 32 | 11.2 | 1.9 | 21.3 | 5.9 | 2.0 | 0.5 | 1.0 | 4.1 |
| EXAMPLE 33 | 15.0 | 5.0 | 74.9 | 3.0 | 3.6 | 0.4 | 1.6 | 8.2 |
| EXAMPLE 34 | 24.5 | 1.3 | 32.6 | 18.4 | 4.8 | 1.2 | 5.8 | 4.0 |
| EXAMPLE 35 | 10.2 | 3 | 27.0 | 3.8 | 1.5 | 0.8 | 1.2 | 1.9 |
| EXAMPLE 36 | 25.8 | 3.9 | 99.6 | 6.7 | 3.7 | 1.4 | 5.0 | 2.7 |
| EXAMPLE 37 | 25.3 | 0.8 | 20.2 | 31.6 | 5.5 | 0.2 | 1.3 | 23.9 |
| EXAMPLE 38 | 32.9 | 0.9 | 29.6 | 36.6 | 6.9 | 0.4 | 2.6 | 18.2 |
| EXAMPLE 39 | 8.8 | 5 | 46.1 | 1.7 | 1.0 | 0.3 | 0.3 | 3.4 |
| EXAMPLE 40 | 20.9 | 1.1 | 23.2 | 18.8 | 2.7 | 0.2 | 0.4 | 16.9 |
| EXAMPLE 41 | 14.8 | 6.8 | 100.5 | 2.2 | 2.3 | 1.3 | 2.9 | 1.8 |
| EXAMPLE 42 | 31.9 | 5.9 | 188.8 | 5.4 | 16.6 | 4.2 | 69.1 | 4.0 |
| EXAMPLE 43 | 9.4 | 3 | 32.7 | 2.7 | 2.1 | 0.7 | 1.6 | 2.8 |
| EXAMPLE 44 | 24.2 | 1.4 | 33.4 | 17.5 | 4.7 | 0.1 | 0.6 | 36.2 |
| EXAMPLE 45 | 22.8 | 2.5 | 57.5 | 9.0 | 5.4 | 0.0 | 0.0 | - |
| EXAMPLE 46 | 23.8 | 3.6 | 86.4 | 6.6 | 4.2 | 0.9 | 3.9 | 4.5 |
| EXAMPLE 47 | 6.7 | 1 | 9.2 | 4.9 | 1.3 | 0.2 | 0.2 | 8.7 |
| EXAMPLE 48 | 16.3 | 1.8 | 29.0 | 9.2 | 2.9 | 0.4 | 1.3 | 6.6 |
| EXAMPLE 49 | 26.2 | 2.9 | 76.2 | 9.0 | 4.2 | 0.3 | 1.3 | 13.5 |
| EXAMPLE 50 | 37.9 | 3.1 | 117.1 | 12.3 | 7.7 | 1.1 | 8.1 | 7.3 |
| EXAMPLE 51 | 34.4 | 2.7 | 94.3 | 12.6 | 7.5 | 0.7 | 5.2 | 10.9 |
| EXAMPLE 52 | 6.3 | 2 | 11.5 | 3.5 | 1.4 | 0.1 | 0.2 | 10.0 |
| EXAMPLE 53 | 19.4 | 1.3 | 25.0 | 15.0 | 2.8 | 0.3 | 0.8 | 10.4 |
| EXAMPLE 54 | 21.0 | 0.6 | 11.8 | 37.5 | 3.5 | 0.1 | 0.2 | 70.0 |
| EXAMPLE 55 | 34.1 | 2.1 | 71.3 | 16.3 | 5.8 | 0.4 | 2.4 | 13.8 |
| EXAMPLE 56 | 42.3 | 1.1 | 45.7 | 39.2 | 8.8 | 0.1 | 1.2 | 62.9 |

**Table 5**

| No | PVC | RAW MATERIAL | | | COMPOSITION RATIO |
|---|---|---|---|---|---|
| | | PVC (g) | PLASTICIZER (DBF) (g) | THF (g) | PVC:PLASTICIZER |
| EXAMPLE 57 | **TK-2500PE** | **3** | **6** | **40** | **1 : 2** |
| EXAMPLE 58 | | **2** | **6** | **40** | **1 : 3** |
| EXAMPLE 59 | | **2** | **8** | **45** | **1 : 4** |
| EXAMPLE 60 | | **2** | **10** | **45** | **1 : 5** |
| EXAMPLE 61 | **VICIR S5000** | **3** | **6** | **40** | **1 : 2** |
| EXAMPLE 62 | | **2** | **6** | **40** | **1 : 3** |
| EXAMPLE 63 | | **2** | **8** | **45** | **1 : 4** |
| EXAMPLE 64 | | **2** | **10** | **45** | **1 : 5** |

**Table 6**

| No | PHYSICAL PROPERTIES UNDER 300 V APPLICATION | | | | PHYSICAL PROPERTIES UNDER 100 V APPLICATION | | | |
|---|---|---|---|---|---|---|---|---|
| | DISPLACEMENT (µm) | TACK FORCE (N/cm²) | TACK FORCE x DISPLACEMENT (µ mN/cm²) | DISPLACEMENT /TACK FORCE (µ mcm² /N) | DISPLACEMENT (µm) | TACK FORCE (N/cm²) | TACK FORCE x DISPLACEMENT (µ mN/cm²) | DISPLACEMENT /ACK FORCE (µ mcm²/N) |
| EXAMPLE 57 | 7.0 | 3.9 | 27.5 | 1.8 | 1.7 | 0.5 | 0.9 | 3.3 |
| EXAMPLE 58 | 12.3 | 3.5 | 42.9 | 3.5 | 2.5 | 0.3 | 0.8 | 8.1 |
| EXAMPLE 59 | 16.1 | 3.1 | 50.4 | 5.1 | 4.0 | 0.7 | 2.8 | 5.6 |
| EXAMPLE 60 | 27.8 | 2.8 | 77.3 | 10.0 | 5.2 | 0.6 | 3.1 | 8.8 |
| EXAMPLE 61 | 4.4 | 1.1 | 4.8 | 4.1 | 0.7 | 0.2 | 0.1 | 4.4 |
| EXAMPLE 62 | 9.1 | 1.0 | 9.5 | 8.8 | 1.2 | 0.1 | 0.1 | 10.9 |
| EXAMPLE 63 | 11.2 | 0.8 | 9.4 | 13.3 | 2.4 | 0.2 | 0.5 | 12.0 |
| EXAMPLE 64 | 19.1 | 0.8 | 14.7 | 24.8 | 2.9 | 0.2 | 0.6 | 13.2 |

While the present invention has been described by way of the embodiments, the technical scope of the present invention is not limited to the above-described embodiments. It is apparent to persons skilled in the art that various alterations or improvements can be added to the above-described embodiments. In addition, the matters described with regard to the particular embodiment can be applied to other embodiments within a range without causing technical contradictions. In addition, each constitutional element may have features similar to those of other constitutional elements which have a same name and have different numerals. It is also apparent from the described scope of the claims that the embodiments added with such alterations or improvements can be included in the technical scope of the present invention.

Note that the operations, procedures, steps, stages, or the like of each process performed by a device, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCES

100: actuator;
110: piezoelectric element;
112: cathode;
114: anode;
116: polymer layer;
120: driving device;
130: wiring;
200: sensor;
210: piezoelectric element;
220: detection device; and
230: wiring.

## Claims

1. A gel composition comprising a polyvinyl chloride-based resin and a plasticizer and exhibiting a gel state at 20°C, wherein
the plasticizer is at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof.

2. The gel composition according to claim 1, wherein
the plasticizer is at least one selected from a group consisting of di-2-ethylhexyl isophthalate (DOIP), di-2-ethylhexyl terephthalate (DOTP), dibutyl fumarate (DBF), di-2-ethylhexyl fumarate (DOF), methyl acetyl ricinoleate (MAR), acetyl tributyl citrate (ATBC), diethyl fumarate (DEF), diethyl maleate (DEM), dibutyl maleate (DBM), triethyl citrate (TEC), tributyl citrate (TBC) and derivatives thereof, and salts thereof.

3. The gel composition according to claim 1, wherein
in a state in which a voltage of 300 V is applied to a sample having a height of 1.5 cm, a width of 1.5 cm, and a thickness of 0.03 cm, using an aluminum electrode as an anode, a tack force measured as a force required to peel the sample in contact from the anode is 0.5 N/cm² or more.

4. The gel composition according to claim 1, wherein
when a voltage of 300 V is applied to a sample having a height of 1.5 cm, a width of 1.5 cm, and a thickness of 0.03 cm, using a stainless-steel mesh electrode having a wire diameter of 0.18 mm, an opening size of 0.67 mm, and an aperture ratio of 62% as an anode, a displacement of the sample is 0.5 µm or more.

5. The gel composition according to claim 1, wherein
the plasticizer is at least one selected from a group consisting of di-2-ethylhexyl isophthalate (DOIP) and derivatives thereof, and salts thereof, and
the gel composition comprises (i) 1000 parts by mass or less of the plasticizer with respect to 100 parts by mass of the polyvinyl chloride-based resin, or (ii) 200 parts by mass or more of the plasticizer with respect to 100 parts by mass of the polyvinyl chloride-based resin.

6. The gel composition according to claim 1, wherein
the plasticizer is at least one selected from a group consisting of di-2-ethylhexyl terephthalate (DOTP) and derivatives thereof, and salts thereof, and
the gel composition comprises 200 parts by mass or more of the plasticizer with respect to 100 parts by mass of the polyvinyl chloride-based resin.

7. A member formed from the composition according to any one of claims 1 to 6.

8. An electronic element comprising:
a first electrode and a second electrode; and
a polymer layer which is arranged between the first electrode and the second electrode and includes the gel composition according to any one of claims 1 to 6.

9. An electronic device comprising the electronic element according to claim 8.

10. A method for producing a gel composition, comprising
mixing a polyvinyl chloride-based resin, a plasticizer, and a solvent;
drying a mixture of the polyvinyl chloride-based resin, the plasticizer, and the solvent obtained in the mixing to remove a part of the solvent from the mixture, wherein
the mixture includes 100 parts by mass or more and 1000 parts by mass or less of the plasticizer with respect to 100 parts by mass of the polyvinyl chloride-based resin, and
the plasticizer is at least one selected from a group consisting of isophthalic acid esters, terephthalic acid esters, fumaric acid esters, acetyl ricinoleic acid esters, acetyl citric acid esters, citric acid esters, adipic acid esters selected from di-2-ethylhexyl adipate (DOA) and diisononyl adipate (DINA), maleic acid esters and derivatives thereof, and salts thereof.

11. The method for producing a gel composition according to claim 10, wherein
a ratio of a total mass of the polyvinyl chloride-based resin and the plasticizer to a mass of the mixture is 80 mass% or more, and
the plasticizer is at least one selected from a group consisting of isophthalic acid esters, terephthalic acid esters, fumaric acid esters, acetyl ricinoleic acid esters, citric acid esters, acetyl citric acid esters, adipic acid esters selected from di-2-ethylhexyl adipate (DOA) and diisononyl adipate (DINA), maleic acid esters and derivatives thereof, and salts thereof.

12. A gel composition comprising a polyvinyl chloride-based resin and a plasticizer and exhibiting a gel state at 20°C, wherein
a product of:
in a state in which a voltage of 300 V is applied to a sample having a height of 1.5 cm, a width of 1.5 cm, and a thickness of 0.03 cm, using an aluminum electrode as an anode, a tack force (N/cm²) measured as a force required to peel the sample in contact from the anode; and
when a voltage of 300 V is applied to a sample having a height of 1.5 cm, a width of 1.5 cm, and a thickness of 0.03 cm, using a stainless-steel mesh electrode having a wire diameter of 0.18 mm, an opening size of 0.67 mm, and an aperture ratio of 62% as an anode, a displacement (µm) of the sample
is 20 µm·N/cm² or more.

13. A gel composition comprising a polyvinyl chloride-based resin and a plasticizer and exhibiting a gel state at 20°C, wherein
a displacement/tack force obtained by dividing
when a voltage of 300 V is applied to a sample having a height of 1.5 cm, a width of 1.5 cm, and a thickness of 0.03 cm, using a stainless-steel mesh electrode having a wire diameter of 0.18 mm, an opening size of 0.67 mm, and an aperture ratio of 62% as an anode, a displacement (µm) of the sample
by, in a state in which a voltage of 300 V is applied to a sample having a height of 1.5 cm, a width of 1.5 cm, and a thickness of 0.03 cm, using an aluminum electrode as an anode, a tack force (N/cm²) measured as a force required to peel the sample in contact from the anode
is 1.5 µm·cm²/N or more.
